# EUROPÄISCHE PATENTSCHRIFT

(11) **EP 0 833 165 B1**
(45) Veröffentlichungstag und Bekanntmachung des Hinweises auf die Patenterteilung: **23.02.2005**
(21) Anmeldenummer: 97115938.9
(22) Anmeldetag: 12.09.1997
(51) Int. Cl.: G01R 31/01

(54) **Prüfeinrichtung für Kraftfahrzeuge in der Endkontrolle oder Endmontage**
Test device for motor vehicles at the final checking or final assembly stage
Appareil de test pour automobiles lors de l'inspection ou du montage final

(30) Priorität: 26.09.1996 DE 29616803 U
(43) Veröffentlichungstag der Anmeldung: 01.04.1998
(73) Patentinhaber: SIEMENS AKTIENGESELLSCHAFT, 80333 München (DE)
(72) Erfinder: Niemeyer, Heinrich, Dipl.-Ing., 90559 Burgthann (DE); Schicktanz, Heinrich, Dipl.-Ing., 90542 Eckental (DE); Smidt, Gernot, Dipl.-Ing., 91180 Heideck (DE); Spies, Walter, Dipl.-Ing., 92361 Berngau (DE); Sporbert, Andreas, Dipl.-Ing., 90475 Nürnberg (DE)

(56) Entgegenhaltungen:
- EP-A- 0 221 383
- EP-A- 0 685 723
- DE-A- 4 328 600
- FR-A- 2 552 228
- GB-A- 2 290 631
- US-A- 4 207 611
- PATENT ABSTRACTS OF JAPAN vol. 011, no. 302 (M-629), 2. Oktober 1987 & JP 62 094443 A (NISSAN MOTOR CO LTD), 30. April 1987
- DREYER D: "KFZ-TESTER MIT DRAHTLOSER MESSWERTAUFNAHME" ELEKTRONIK, Bd. 38, Nr. 14, 7. Juli 1989, Seiten 78-80, 82, XP000030413

## Beschreibung

Die Erfindung bezieht sich auf eine Prüfeinrichtung für mit stromführenden elektrischen Komponenten versehene Produkte, insbesondere Kraftfahrzeuge in der Endkontrolle oder Endmontage.

Um das ordnungsgerechte Verhalten von elektrischen Komponenten von aus der Fertigung kommenden Kraftfahrzeugen zu überprüfen, ist es bislang üblich, den Akkumulator abzutrennen, die Trennstelle mit einem Strommeßgerät zu überbrücken und dann eine Analyse der in Abhängigkeit von den Betriebszuständen des Fahrzeugs fließenden elektrischen Ströme vorzunehmen. Dieses Verfahren wird auch als electro-check-out (ECOS) bezeichnet. Der dadurch bedingte technische Aufwand ist jedoch nicht unerheblich. Selbstverständlich kann am gleichen Prüfplatz, wo die Stromanalyse stattfindet, auch das Parametrieren elektronischer Komponenten, z.B. des Airbags, erfolgen. Ebenso kann dort auch eine Abgasanalyse vorgenommen werden. Heutzutage werden die drei geschilderten Prozesse meist durch Bedienung von Einzelgeräten vorgenommen.

Aus der EP 0 221 383 A1 ist eine Testeinrichtung für Vorrichtungen in Kraftfahrzeugen bekannt. Hierbei werden von Messsensoren aufgenommene Signale über einen Sender an eine Testeinrichtung übertragen.

Weiterhin ist aus den Patent Abstracts of Japan vol. 011, N0. 302(M-629) Oktober 1987 ein Diagnosesystem für Fahrzeuge bekannt. Dieses weist eine Selbstdiagnoseeinheit auf, die in einer On-Board-Einheit im Fahrzeug installiert ist. Das Diagnosesystem erfasst über Sensoren Fahrzeugdaten, und kann diese über eine Anzeigeeinheit ausgeben und über eine Sende- /Empfangsstation an ein Servicezentrum übertragen. Das Servicezentrum verfügt über eine Auswerteeinheit, welche eine Behandlungsmethode vorschlägt und an das Diagnosesystem überträgt, um Probleme zu lösen, die sich auf die übertragenen Daten beziehen.

Ferner ist aus der EP 0 685 723 A2 eine Vorrichtung zur Diagnose von Kraftfahrzeugen bekannt. Diese enthält einen Hand-Held Tester sowie eine Feststation, die über eine Sende-/Empfangseinrichtung drahtlos zusammenwirken. Hierüber kann der Handheldtester Diagnoseprogramme von der Feststation anfordern. Die Feststation kann hierbei auf einen internen Diagnose-Programm-Speicher zurückgreifen, oder über eine Verbindung auf einen Zentralrechner, der z.B. bei einem Kraftfahrzeughersteller vorhanden ist.

Schließlich ist aus der GB 2 290 631 A ebenfalls ein Diagnosesystem für Kraftfahrzeuge bekannt. Hierbei ist ein portables Diagnosegerät über einen Kabelbaum mit einer elektronischen Kontrolleinrichtung im Kraftfahrzeug verbindbar. Weiterhin ist das portable Diagnosegerät über eine kabellose Datenverbindung mit einem externen Computer verbunden. Dieser analysiert übertragene Daten und stellt Reparaturanleitungen zur Verfügung, welche an das portable Diagnosegerät übertragen werden.

Aufgabe der Erfindung ist es, eine Prüfeinrichtung der eingangs genannten Art so auszubilden, daß eine universelle, einfache und durchgängige Prüfung mit einem Gerät ermöglicht wird. In der Automobilindustrie sind momentan übrigens Strom/Spannungstests, Steuergeräteinstellungen, Abgasprüfungen, Rollenprüfstandsuntersuchungen (mit ABS) und Fahrwerksuntersuchungen (ALS: Achse, Lenkung, Scheinwerfer) üblich.

Gemäß der Erfindung wird diese Aufgabe durch die im Patentanspruch 1 angegebene Prüfeinrichtung gelöst. Vorteilhafte weitere Ausführungen der Erfindung sind in den Unteransprüchen angegeben.

Während in diesem Fall stets eine Meldung "OK" bzw. "nicht OK" an die Zentrale gelangt, kann für den letzteren Fall gemäß einer ersten vorteilhaften Ausbildung der Erfindung auch der jeweilige Istwertverlauf an die Zentrale meldbar sein, damit dort eingehendere Analysen vorgenommen werden können.

Dadurch, daß mit dem mobilen Gerät ein Barcodeleser zum Identifizieren des diesbezüglich markierten Produkts integriert ist, ist insbesondere dann, wenn es sich bei den Produkten um solche mit unterschiedlichen Sollwerten oder Sollwertverläufen handelt, eine eindeutige Wertzuordnung im mobilen Gerät möglich und auch die Rückmeldung an die Zentrale kann mit einem Identifizierungssignal für das Produkt versehen werden.

Für den Fall, daß Parametrierungen am Produkt vorgenommen werden sollen, sind z.B. Parameter für den Airbag eines Kraftfahrzeugs einzustellen, ist es gemäß einer weiteren vorteilhaften Ausbildung der Erfindung möglich, daß das mobile Gerät über eine Schnittstelle mit dem Produkt verbindbar ist und die jeweiligen elektrischen Komponenten im Dialog parametrierbar sind.

Im Interesse einer hohen Integration aller Prüfeinrichtungen ist es auch möglich, daß Istwerte weiterer Produktanalysen, insbesondere Abgaswerte oder Werte aus der Motorsteuerelektronik, im mobilen Gerät auf das Einhalten von vorgegebenen Werten überprüfbar sind.

Geräte im industriellen Einsatz müssen auch unter rauhen Umgebungsbedingungen zuverlässig betrieben werden können. Daher ist es vorteilhaft, daß das mobile Gerät an seinen Kanten Rammschutzelemente aufweist.

Zur leichteren Handhabung kann das mobile Gerät seitliche Tragegriffe innerhalb des Rammschutzbereichs aufweisen.

Eine ergonomisch günstige Anordnung von Bedienelementen zum Ein- und Ausschalten des mobilen Gerätes und zum Auslösen des Barcodelesers ergibt sich dadurch, daß im Griffbereich Schaltmittel zum Auslösen von Schaltfunktionen vorgesehen sind.

Um einen mobilen Betrieb ohne Netzanschluß zu ermöglichen, bietet sich der Einsatz von Akkus in der mobilen Station an. Um diese Energiespeicher aufladen zu können, sind am mobilen Gerät Ladekontakte vorgesehen.

Als Anzeigeelement des mobilen Gerätes kann ein Flachbildschirm und als Eingabeelement kann eine Folientastatur dienen. Dadurch läßt sich ein kompakter, vor Umgebungseinflüssen sicherer Aufbau des mobilen Gerätes erreichen.

Wenn das mobile Gerät zum Testen von Kraftfahrzeugen verwendet wird, und wenn dazu der Bediener auf dem Fahrersitz Platz nehmen muß, ist es aus ergonomischen Gründen günstig, wenn am mobilen Gerät bügelförmige Halterungen vorgesehen sind, mit denen das Gerät am Lenkrad des Fahrzeugs arretierbar ist.

Eine Funkverbindung zwischen Strommeßzange und mobilem Gerät erübrigt ergonomisch ungünstige Kabel.

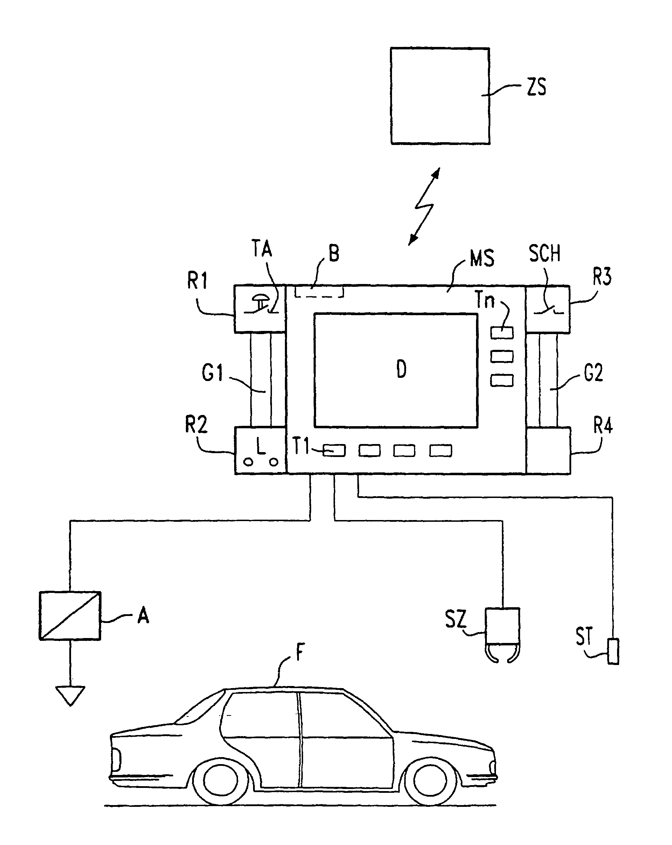

Ein Ausführungsbeispiel der Erfindung ist in der Zeichnung dargestellt und wird im folgenden näher erläutert.

Die Darstellung in Form eines Blockschaubildes zeigt, daß eine Zentralstation ZS über einen bidirektionalen Funkkanal (durch einen Doppelpfeil symbolisiert) mit einer Mobilstation MS kommuniziert. So liefert die Zentralstation ZS Sollwerte oder Sollwertverläufe für elektrische Ströme, wie diese bei bestimmten Bedienhandlungen oder bestimmten Betriebszuständen eines Fahrzeugs auftreten sollen. Diese Bedienhandlungen und Betriebszustände werden von einem Prüfer im Fahrzeug F ausgelöst und mit einer Strommeßzange SZ werden die diesbezüglich sich einstellenden Ströme erfaßt.

Die Mobilstation MS ist näherungsweise quaderförmig ausgebildet. Dabei ist eine Betätigungs- und Anzeigeebene dem Betrachter zugewandt, wobei als Anzeigeelement ein Flachbildschirm, ein Display D, vorgesehen ist, und wobei zum Eingeben von Bedienhandlungen eine Folientastatur mit Einzeltasten vorgesehen ist, von denen die Tasten T1 und Tn bezeichnet sind. Links und rechts neben der somit gegebenen Bedienfläche sind zwei Griffe G1 und G2 angeordnet, an deren Enden Rammschutzelemente R1 bis R4 aus elastischem Material angeordnet sind, so daß auch ein hartes Anschlagen der Mobilstation MS nicht zu Schäden am zu prüfenden Produkt (Lackschäden an Fahrzeugen!). Im Bereich der Griffe G1 und G2 befinden sich übrigens Schaltmittel zum Auslösen von Schaltfunktionen an ergonomisch sehr günstiger Stelle. So ist zum einen ein Taster TA zum Auslösen eines Barcodelesers B, der gestrichelt angedeutet ist, vorgesehen, zum anderen ist im Bereich des Rammschutzes R3 ein Ein-/Ausschalters SCH für die Mobilstation MS plaziert. Der Barcodeleser B dient dazu, daß Barcodekennungen am Produkt, so auch am Fahrzeug F, gelesen werden können, damit die Mobilstation MS weiß, welche Sollwerte bzw. Sollwertverläufe jeweils aktuell anzuwenden sind und damit nach Durchführen der Untersuchung der Sollwerte oder Sollwertverläufe eine Rückmeldung an die Zentralstation ZS erfolgen kann, die nicht nur die Information darüber enthält, ob Sollwert bzw. Sollwertverlauf eingehalten oder nicht eingehalten wurde, sondern die auch aussagt, um welches Fahrzeug es sich bei der Prüfung gehandelt hat.

An dieser Stelle sei noch auf einige konstruktive Besonderheiten der Mobilstation MS eingegangen. So können auf der dem Betrachter abgewandten Seite der Mobilstation MS zwei hakenförmige Bügel vorgesehen sein, die es ermöglichen, daß die Mobilstation MS über das Lenkrad des Fahrzeugs F gehängt werden kann, so daß. der Bediener beide Hände frei hat, um Betätigungen entweder an Elementen des Fahrzeugs F bzw. um Eingaben in die Mobilstation MS vorzunehmen. Im Bereich des Rammschutzes, beispielsweise des Rammschutzes R2, können auch Ladekontakte L vorgesehen sein, die ein Einhängen der Mobilstation MS in eine Ladevorrichtung ermöglichen. Die Ausrichtung der Ladekontakte kann selbstverständlich an die örtlichen Gegebenheiten erfolgen.

An der Mobilstation MS kann ferner eine Schnittstelle ST vorgesehen sein, über welche die Mobilstation MS mit einem Gegenstecker des Fahrzeugs F verbunden werden kann, wobei diese Verbindung beispielsweise über eine normierte OBDII-Schnittstelle erfolgen kann. Wenn ein solches Ankoppeln der Mobilstation MS mit der relevanten Fahrzeugelektronik vorgenommen worden ist, kann im Dialogverkehr ein Parametrieren des Airbags, der Motorelektronik und anderer elektronischer Komponenten des Fahrzeugs F vom Bediener vorgenommen werden.

Selbstverständlich ist es auch möglich, daß die Mobilstation MS mit einem Analysegerät A verbunden ist, das die Abgaswerte des Fahrzeugs F aufnimmt. Ebenso wie die Sollwerte für den Strom oder die Sollwertverläufe für den Strom können auch die relevanten Parameter für die zu parametrierenden Geräte und auch die Sollwerte für die Abgasanalyse von der Zentralstation ZS an die Mobilstation MS über den bidirektionalen Funkkanal übermittelt werden.

Selbstverständlich können mehrere Mobilstationen mit einer gemeinsamen Zentralstation kommunizieren. Als Übertragungswege dienen dann voneinander unabhängige Funkkanäle.

Ferner ist es möglich, daß die Stromzange oder andere Meßgeräte nicht per Kabel, sondern ebenfalls drahtlos im Datenaustausch mit ihrer Mobilstation stehen. Wenn als Übertragungsweg auch hier ein Funkkanal dient, kann dabei derselbe Funkkanal verwendet werden, der für die zugehörige Mobilstation bei ihrer Kommunikation mit der Zentralstation verwendet wird.

## Patentansprüche

1. Prüfeinrichtung für mit stromführenden elektrischen Komponenten versehene Produkte, insbesondere Kraftfahrzeuge in der Endkontrolle oder Endmontage, mit
a) einer Strommeßzange (SZ) zur berührungslosen Erfassung von Istwerten oder Istwertverläufen von Strömen elektrischer Komponenten,
b) einem mobilen Gerät (MS), welches mit der Strommesszange (SZ) drahtlos verbindbar ist, vorzugsweise über einen Funkkanal, und womit die Einhaltung von Sollwerten oder Sollwertverläufen von Strömen der elektrischen Komponenten überwachbar ist, und mit
c) einer Zentrale (ZS), die über einen leitungslosen bidirektionalen Übertragungsweg, insbesondere einen Funkkanal, mit dem mobilen Gerät (MS) verbindbar ist, und worüber die Sollwerte oder Sollwertverläufe für Ströme an das mobile Gerät (MS) übertragbar sind und das Ergebnis von deren Überprüfung an die Zentrale (ZS) meldbar ist.

2. Prüfeinrichtung nach Anspruch 1, **dadurch gekennzeichnet, daß** auch Istwertverläufe an die Zentrale (ZS) meldbar sind.

3. Prüfeinrichtung nach Anspruch 1 oder 2, **dadurch gekennzeichnet, daß** mit dem mobilen Gerät (MS) ein Barcodeleser (B) zum Identifizieren des diesbezüglich markierten Produkts (F) integriert ist.

4. Prüfeinrichtung nach einem der vorstehenden Ansprüche, **dadurch gekennzeichnet, daß** das mobile Gerät (MS) über eine Schnittstelle (ST) mit dem Produkt (F) verbindbar ist und elektrische Komponenten, beispielsweise die Steuergeräte für Airbags, im Dialog parametrierbar sind.

5. Prüfeinrichtung nach einem der vorstehenden Ansprüche, **dadurch gekennzeichnet, daß** auch Istwerte weiterer Produktanalysen, insbesondere Abgaswerte oder Werte aus der Motorsteuerelektronik, im mobilen Gerät auf das Einhalten von vorgegebenen Werten überprüfbar sind.

6. Prüfeinrichtung nach einem der vorstehenden Ansprüche, **dadurch gekennzeichnet, daß** das mobile Gerät (MS) an seinen Kanten Rammschutzelemente (R1 bis R4) aufweist.

7. Prüfeinrichtung nach Anspruch 6, **dadurch gekennzeichnet, daß** das mobile Gerät (MS) seitliche Tragegriffe (G1,G2) innerhalb des Rammschutzbereiches aufweist.

8. Prüfeinrichtung nach Anspruch 7, **dadurch gekennzeichnet, daß** im Griffbereich Schaltmittel (TA, SCH) zum Auslösen von Schaltfunktionen vorgesehen sind.

9. Prüfeinrichtung nach einem der vorstehenden Ansprüche, **dadurch gekennzeichnet, daß** am mobilen Gerät (MS) Ladekontakte (L) zum Aufladen eines Energiespeichers vorgesehen sind.

10. Prüfeinrichtung nach einem der vorstehenden Ansprüche, **dadurch gekennzeichnet, daß** als Anzeigeelement des mobilen Geräts ein Flachbildschirm (D) vorgesehen ist.

11. Prüfeinrichtung nach einem der vorstehenden Ansprüche, **dadurch gekennzeichnet, daß** als Eingabe eine Folientastatur (T1 bis Tn) vorgesehen ist.

12. Prüfeinrichtung nach einem der vorstehenden Ansprüche, **dadurch gekennzeichnet, daß** am mobilen Gerät vorzugsweise bügelförmige Halterungen vorgesehen sind, mit denen das Gerät (MS) am Lenkrad eines Fahrzeugs (F) arretierbar ist.

## Claims

1. A test device for products equipped with current-carrying electrical components, in particular for motor vehicles at the final checking or final assembly stage,
comprising
a) a current measuring probe (SZ) for the contactless recording of actual values or actual-value curves of currents of electrical components,
b) a mobile device (MS) which can be connected wirelessly to the current-measuring probe, preferably via a radiofrequency channel, and with which the adherence of currents of the electrical components to setpoint values or setpoint-value curves can be monitored, and comprising
c) a master station (ZS), which can be connected via a lineless bidirectional transmission path, in particular a radiofrequency channel, to the mobile device (MS) and via which the setpoint values or setpoint-value curves for currents can be transmitted to the mobile device (MS) and the result of the checking thereof can be reported to the master station (ZS).

2. A test device according to Claim 1, **characterised in that** actual-value curves can also be reported to the master station (ZS).

3. A test device according to Claim 1 or Claim 2, **characterised in that** a bar-code reader (B) is integrated with the mobile device (MS) for identifying the product (F) marked in this respect.

4. A test device according to any one of the preceding claims, **characterised in that** the mobile device (MS) can be connected via an interface (ST) to the product (F) and **in that** electrical components, for example the control devices for airbags, can be parameterised interactively.

5. A test device according to any one of the preceding claims, **characterised in that** actual values of further product analyses, in particular exhaust-gas values or values from the engine control electronics, can also be checked in the mobile device for compliance with predetermined values.

6. A test device according to any one of the preceding claims, **characterised in that** the mobile device (MS) has protective elements (R1 to R4) on its edges.

7. A test device according to any one of the preceding claims, **characterised in that** the mobile device (MS) has side carrying handles (G1, G2) inside the protected area.

8. A test device according to Claim 7, **characterised in that** switching means (TA, SCH) for initiating switching functions are provided close to the handle.

9. A test device according to any one of the preceding claims, **characterised in that** charging contacts (L) are provided on the mobile device (MS) for charging an energy store.

10. A test device according to any one of the preceding claims, **characterised in that** a flat-panel screen (D) is provided as the display element of the mobile device.

11. A test device according to any one of the preceding claims, **characterised in that** a membrane keyboard (T1 to Tn) is provided as an input mechanism.

12. A test device according to any one of the preceding claims, **characterised in that** clip-shaped holders are preferably provided on the mobile device, by means of which the device (MS) can be secured to the steering wheel of a vehicle (F).

## Revendications

1. Dispositif de contrôle de produits munis de composants électriques dans lesquels passe du courant, notamment de véhicules automobiles au contrôle final ou au montage final, comprenant
a) une pince (SZ) de mesure du courant pour la détection sans contact de valeurs réelles ou de courbes de valeurs réelles de courant de composants électriques,
b) un appareil (MS) mobile qui peut être relié sans fil à la pince (SZ) de mesure de courant, de préférence par un canal radio, et par lequel on peut contrôler le respect de valeurs de consigne ou de courbes de valeurs de consigne de courant des composants électriques, et
c) une centrale (ZS) qui peut être reliée à l'appareil (MS) mobile par une voie de transmission bidirectionnelle sans fil, notamment par un canal radio, et par laquelle on peut transmettre les valeurs de consigne ou les courbes de valeurs de consigne des courants à l'appareil (MS) mobile et envoyer le résultat de leur contrôle à la centrale (ZS).

2. Dispositif de contrôle suivant la revendication 1, **caractérisé en ce que** des courbes de valeurs réelles peuvent être envoyées aussi à la centrale (ZS).

3. Dispositif de contrôle suivant la revendication 1 ou 2, **caractérisé en ce que** fait partie de l'appareil (MS) mobile un lecteur (B) de code barres d'identification du produit (F) marqué de cette façon.

4. Dispositif de contrôle suivant l'une des revendications précédentes, **caractérisé en ce que** l'appareil (MS) mobile peut être relié par une interface (ST) au produit (F), et des composants électriques, par exemple les appareils de commande de coussins d'air, sont paramétrables en dialogue.

5. Dispositif de contrôle suivant l'une des revendications précédentes, **caractérisé en ce que** le respect de valeurs prescrites peut être contrôlé dans l'appareil mobile, également pour des valeurs réelles d'autres analyses de produits, notamment des valeurs de gaz d'échappement ou des valeurs de l'électronique de commande du moteur.

6. Dispositif de contrôle suivant l'une des revendications précédentes, **caractérisé en ce que** l'appareil (MS) mobile a, sur ses bords, des éléments (R1 à R4) de protection vis-à-vis des chocs.

7. Dispositif de contrôle suivant la revendication 6, **caractérisé en ce que** l'appareil (MS) mobile a, dans la zone de la protection vis-à-vis des chocs, des poignées (G1, G2) pour le porter.

8. Dispositif de contrôle suivant la revendication 7, **caractérisé en ce qu'**il est prévu, dans la zone des poignées, des moyens (TA, SCH) de commutation pour déclencher les fonctions de commutation.

9. Dispositif de contrôle suivant l'une des revendications précédentes, **caractérisé en ce qu'**il est prévu sur l'appareil (MS) mobile des contacts (L) de charge pour le chargement d'un accumulateur d'énergie.

10. Dispositif de contrôle suivant l'une des revendications précédentes, **caractérisé en ce qu'**il est prévu comme élément d'affichage de l'appareil mobile un écran (D) plat.

11. Dispositif de contrôle suivant l'une des revendications précédentes, **caractérisé en ce qu'**il est prévu comme dispositif d'entrée un clavier (T1 à Tn) à effleurement.

12. Dispositif de contrôle suivant l'une des revendications précédentes, **caractérisé en ce qu'**il est prévu sur l'appareil mobile, de préférence, des pièces de fixation en forme d'étriers par lesquelles l'appareil (MS) peut être bloqué sur le volant d'un véhicule (F) automobile.
